# EUROPEAN PATENT APPLICATION

(11) **EP 2 293 454 A2**
(43) Date of publication of application: **09.03.2011**
(21) Application number: 10174953.9
(22) Date of filing: 01.09.2010
(51) Int. Cl.: H04B 1/04

(54) **Radio device and fault position specifying method**

(30) Priority: 03.09.2009 JP 2009204074
(71) Applicant: FUJITSU LIMITED, Kawasaki-shi, Kanagawa 211-8588 (JP)
(72) Inventor: Sato, Kenichi, Kawasaki-shi Kanagawa 211-8588 (JP)
(74) Representative: Fenlon, Christine Lesley

(57) **Abstract**

A radio device includes a radio unit to perform modulation processing on a signal, an antenna to transmit and receive signals to and from an external unit, a cable to connect the radio unit to the antenna, a reflection time calculation unit to calculate a reflection time taken from after the transmission signal is input into a prescribed part of the radio unit until a transmission signal which is output from the radio unit is reflected on a path from the cable to the antenna is fed back to the prescribed part of the radio device, and a fault position specifying unit to specify a position candidate at which a fault occurs on the cable based on the calculated reflection time when the calculated reflection time is less than a reflection time threshold value.

## Description

### FIELD

The embodiments discussed herein relate to a radio device and a fault position specifying method.

### BACKGROUND

Recently, a radio device such as a base transceiver station has been proposed which detects whether or not an antenna of the radio device or a cable as a transmission path has a fault. The above-described radio device detects a reflected wave of a transmission signal, which is reflected by the antenna of the radio device, and determines that the antenna or the cable has a fault if a power value of the reflected wave is larger than a prescribed value.

The above-described radio device performs distortion compensation on a transmission signal. For example, a signal transmitted by the radio device is distorted by being modulated or amplified. Therefore, the radio device compensates for a distortion occurring in the transmission signal by feeding back the transmission signal after being modulated or amplified to a distortion compensation circuit.

In recent years, a radio device has been proposed that updates a distortion compensation coefficient used for distortion compensation processing and further stops distortion compensation coefficient updating processing if a power value of an unwanted wave as a signal transmitted from another system is or larger than a prescribed value (see, for example, Japanese Laid-Open Patent Publication No. 2005-142881, No. 2006-197545). According to the technique, it is possible to prevent the distortion compensation coefficient from being updated to a wrong value because the unwanted wave is mixed into a feedback signal.

However, the above-described technique may not specify the fault position of the radio device. For example, the technique for determining occurrence of a fault based on the power value of the reflected wave may determine whether or not a fault occurs on a cable or an antenna but may not specify which position on a path from the cable to the antenna the fault occurs. Since a cable of tens of meters may be used for the radio device, maintenance work may be complex if the fault position may not be specified.

Even though the technique for stopping the distortion compensation coefficient updating processing when the power value of an unwanted wave is larger than the prescribed power value, the fault position may not be specified.

Accordingly, it is considered desirable to provide a radio device and a fault position specifying method for specifying a fault position.

### SUMMARY

According to an aspect of the invention, a radio device includes a radio unit to perform modulation processing on a signal, an antenna to transmit and receive signals to and from an external unit, a cable to connect the radio unit to the antenna, a reflection time calculation unit to calculate a reflection time taken from after the transmission signal is input into a prescribed part of the radio unit until a transmission signal which is output from the radio unit is reflected on a path from the cable to the antenna is fed back to the prescribed part of the radio device, and a fault position specifying unit to specify a position candidate at which a fault occurs on the cable based on the calculated reflection time when the calculated reflection time is less than a reflection time threshold value.

Advantages of the invention may be realized and attained by at least the features, elements, and combinations particularly pointed out in the claims.

It is to be understood that both the foregoing general description and the following detailed description are exemplary and explanatory and are not restrictive of the invention, as claimed.

### BRIEF DESCRIPTION OF THE DRAWINGS

FIG.1 is a diagram of a configuration example of a radio device according to a first embodiment,

FIG.2 is a diagram of a configuration example of a radio device according to a second embodiment,

FIG.3 is an explanation diagram of an example of a fault position specifying processing by the radio device according to the second embodiment,

FIG.4 is a flowchart illustrating the fault position specifying processing performed by the radio device according to the second embodiment, and

FIG.5 is a diagram illustrating a configuration example of a radio device that includes a plurality of antennas.

### DETAILED DESCRIPTION OF EMBODIMENTS

Based on the figures, description will be made below of embodiments of a radio device and a fault position specifying method.

In the figures, dimensions and/or proportions may be exaggerated for clarity of illustration. It will also be understood that when an element is referred to as being "connected to" another element, it may be directly connected or indirectly connected, i.e., intervening elements may also be present. Further, it will be understood that when an element is referred to as being "between" two elements, it may be the only element layer between the two elements, or one or more intervening elements may also be present.

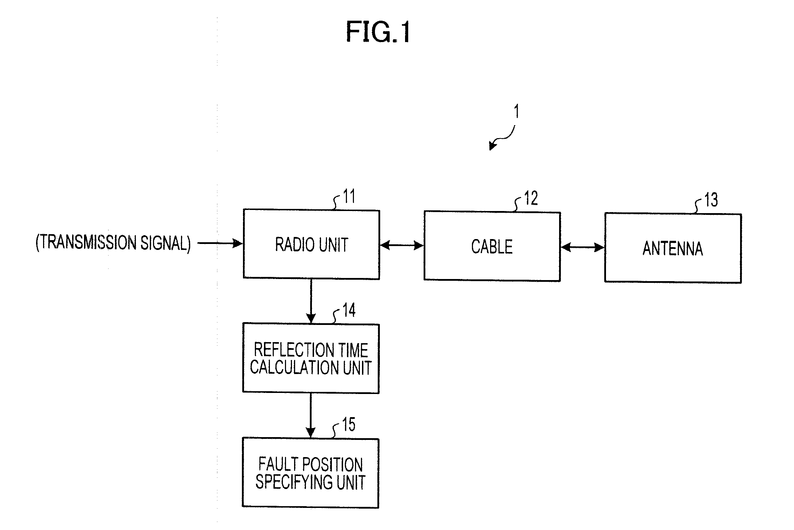

As illustrated in FIG.1, the radio device 1 according to the first embodiment includes a radio unit 11, a cable 12, an antenna 13, a reflection time calculation unit 14, and a fault position specifying unit 15.

The radio unit 11 performs modulation processing and amplification processing on a transmission signal. The cable 12 connects the radio unit 11 to the antenna 13. The antenna 13 transmits and receives signals to and from one or more external units.

For example, transmission signals that are output from the radio unit 11 to the cable 12 are transmitted to the external unit via the antenna 13; however, all or some of the transmission signals are reflected on a path from the cable 12 to the antenna 13 and fed back into the radio unit 11. Hereinafter, a transmission signal that is reflected on the path from the cable 12 to the antenna 13 is referred to as a "reflected wave."

The reflection time calculation unit 14 calculates a reflection time taken from after the transmission signal is input into a prescribed part of the radio unit 11 until the reflected wave of the transmission signal is fed back to the prescribed part of the radio unit 11.

If the reflection time calculated by the reflection time calculation unit 14 is less than a reflection time threshold value as a prescribed threshold value, the fault position specifying unit 15 specifies a fault position candidate on the cable 12 based on the calculated reflection time.

For example, in the radio device 1, the reflection time, which is measured in a state in which the radio device 1 has no fault, is set as the reflection time threshold value. In this case, based on a difference between the reflection time threshold value and the reflection time calculated by the reflection time calculation unit 14, the fault position specifying unit 15 specifies the fault position candidate on the cable 12. For example, as the difference between the reflection time threshold value and the reflection time becomes larger, then the fault position specifying unit 15 determines that the transmission signal is reflected in a position closer to the radio unit 11 on the cable 12 and specifies such a reflection position as the fault position candidate. As the difference between the reflection time threshold value and the reflection time becomes smaller, the fault position specifying unit 15 determines that the transmission signal is reflected in the position closer to the antenna 13 on the cable 12 and specifies such a reflection position as the fault position candidate.

As described above, the radio device 1 according to the first embodiment specifies the fault position candidate on the cable 12 if the reflection time is less than the reflection time threshold value. Accordingly, for example, based on the fault position candidate specified by the fault position specifying unit 15, an administrator or the like of the radio device 1 may check the position where a fault may occur on the cable 12 and specify the fault position.

In a second embodiment, description will be made of an example where the radio device described in the first embodiment is used as a radio device that performs distortion compensation on a transmission signal.

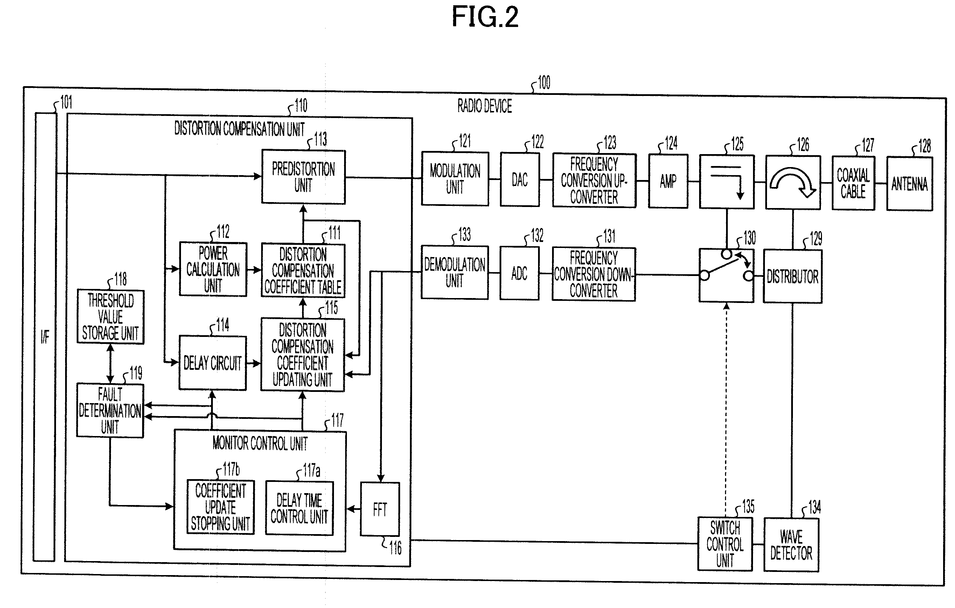

FIG.2 is a diagram illustrating a configuration example of a radio device 100 according to the second embodiment. The configuration of the radio device 100 illustrated in FIG.2 illustrates a configuration of a transmission system.

The radio device 100 illustrated in FIG.2 is, for example, a base transceiver station, a relay station or the like that relays a signal transmitted and received between the base transceiver station and a mobile station. As illustrated in FIG.2, the radio device 100 includes an interface (hereinafter referred to as "I/F") 101, a distortion compensation unit 110, a modulation unit 121, a Digital to Analog Converter (DAC) 122, a frequency conversion up-converter 123, an amplifier (AMP) 124, an coupler 125, a circulator 126, a coaxial cable 127, an antenna 128, a distributor 129, a Radio Frequency (RF) switch 130, a frequency conversion down-converter 131, an Analog to Digital Converter (ADC) 132, a demodulation unit 133, a wave detector 134, and a switch control unit 135.

The distortion compensation unit 110 and each of the units 121 to 126 and 129 to 133 are, for example, included in the radio unit 11 illustrated in FIG.1. The coaxial cable 127 is an example of the cable 12 illustrated in FIG.1. The antenna 128 is an example of the antenna 13 illustrated in FIG.1.

The I/F 101 transmits and receives a signal to and from another device such as an upper device. For example, the I/F 101 connects the radio device 100 to another device and outputs the signal received from the other device to the distortion compensation unit 110. In FIG.2, the radio device 100 transmits the signal, which is input to the I/F 101 from the other device, to the external unit through the antenna 128. The signal includes, for example, user data or control data.

The distortion compensation unit 110, which is, for example, an integrated circuit, compensates for a distortion occurring in the transmission signal input from the I/F 101. The distortion compensation unit 110 performs distortion compensation coefficient updating processing and fault position specifying processing. Description will be made of the distortion compensation processing, the distortion compensation coefficient updating processing, and the fault position specifying processing performed by the distortion compensation unit 110.

The modulation unit 121 is, for example, an integrated circuit and demodulates the transmission signal that is input from the distortion compensation unit 110. The DAC 122 converts the transmission signal demodulated by the modulation unit 121 into an analog signal. The frequency conversion up-converter 123 up-converts a frequency band of the transmission signal into a radio frequency band by mixing the transmission signal and a local oscillation signal. The AMP 124 amplifies the transmission signal that is up-converted by the frequency conversion up-converter 123.

The coupler 125 divides the transmission signals input from the AMP 124 and outputs the transmission signals to the circulator 126 and to the RF switch 130. The circulator 126 outputs the signal input from the coupler 125 to the coaxial cable 127 and outputs the signal that is input from the coaxial cable 127 to the distributor 129. The coaxial cable 127 connects the circulator 126 to the antenna 128.

The distributor 129 divides the signals input from the circulator 126 and outputs the signals to the RF switch 130 and to the wave detector 134. The RF switch 130 switches a connection so that the signal that is to be input to the frequency conversion down-converter 131 becomes either the signal that is output from the coupler 125 or the signal that is output from the distributor 129.

The frequency conversion down-converter 131 down-converts the signal input from the RF switch 130 into a baseband signal. The ADC 132 converts the signal that is down-converted by the frequency conversion down-converter 131 into a digital signal. The demodulation unit 133, which is, for example, an integrated circuit, demodulates the signal that is input from the ADC 132 and feeds back the demodulated signal to the distortion compensation unit 110.

Description will be made of an example of a signal that is transmitted in the radio device illustrated in FIG.2. Description will be made of a case where the connection of the RF switch 130 is switched so that the coupler 125 is connected to the frequency conversion down-converter 131. In this case, the transmission signal output from the distortion compensation unit 110 to the modulation unit 121 is input to the demodulation unit 133 through the coupler 125, the RF switch 130, the frequency conversion down-converter 131, and the ADC 132. The demodulation unit 133 feeds back the transmission signal input from the ADC 132 to the distortion compensation unit 110 as a feedback signal.

If the RF switch 130 is in the connection state of the above-described example, the transmission signal is output to the coaxial cable 127 through the coupler 125 and the circulator 126. All or some of the transmission signals input to the coaxial cable 127 are transmitted to the external unit through the antenna 128 or reflected on the path from the coaxial cable 127 to the antenna 128. At this time, the reflected wave of the transmission signal is output to the wave detector 134 through the coaxial cable 127 and the distributor 129.

Description will be made of a case where the connection of the RF switch 130 is switched so that the distributor 129 is connected to the frequency conversion down-converter 131. In this case, the transmission signal output from the distortion compensation unit 110 to the modulation unit 121 is output to the coaxial cable 127 through the coupler 125 and the circulator 126 in substantially the same manner as in the above-described example. All or some of the transmission signals input from the coaxial cable 127 are transmitted to the external unit through the antenna 128 or reflected on the path from the coaxial cable 127 to the antenna 128. At this time, the reflected wave of the transmission signal is output to the wave detector 134 through the coaxial cable 127, the circulator 126, and the distributor 129. Furthermore, the reflected wave is input to the demodulation unit 133 through the coaxial cable 127, the circulator 126, and the distributor 129, the RF switch 130, the frequency conversion down-converter 131, and the ADC 132. The demodulation unit 133 feeds back the reflected wave input from the ADC 132 to the distortion compensation unit 110.

Even when the radio device 100 is performing transmitting processing, the antenna 128 may receive an unwanted wave as in the signal transmitted from another carrier or system. Accordingly, the feedback signal and the reflected wave described above may include the unwanted wave.

The wave detector 134 detects a signal that includes the reflected wave and the unwanted wave from among the signals input from the distributor 129 and then calculates a power value of the detected signal. The wave detector 134 outputs the calculated power value to the switch control unit 135.

The switch control unit 135, which is a part formed by an integrated circuit or software, for example, controls so that the signal to be input to the distortion compensation unit 110 becomes the feedback signal or the reflected wave by switching the connection of the RF switch 130. For example, if the power value calculated by the wave detector 134 is larger than a wave detection level threshold value as a prescribed threshold value, the switch control unit 135 switches the connection of the RF switch 130 so that the distributor 129 is connected to the frequency conversion down-converter 131. Every time a fixed time elapses, the switch control unit 135 switches the connection of the RF switch 130 so that the distributor 129 is connected to the frequency conversion down-converter 131.

A description will be made of the RF switch 130 that is switched in the above-described manner. When the feedback signal is fed back from the demodulation unit 133, the distortion compensation unit 110 according to the second embodiment performs the distortion compensation processing and the distortion compensation coefficient updating processing. If the reflected wave is fed back from the demodulation unit 133, the distortion compensation unit 110 performs the distortion compensation processing and fault position specifying processing.

If the power value calculated by the wave detector 134 is larger than the detection wave level threshold value, the power value of the reflected wave may be abnormal. If the power value of the reflected wave is abnormal, the coaxial cable 127 or the antenna 128 may have a fault. Therefore, the switch control unit 135 makes the distortion compensation unit 110 perform the fault position specifying processing by switching the connection of the RF switch 130 so that the reflected wave is input to the distortion compensation unit 110.

Even if the power value calculated by the wave detector 134 is smaller than the detection wave level threshold value, a reflection time may be abnormal. If the reflection time is abnormal, the coaxial cable 127 may have a fault. Therefore, each time the prescribed time elapses, the switch control unit 135 makes the distortion compensation unit 110 perform the fault position specifying processing by switching the connection of the RF switch 130 so that the reflected wave is input to the distortion compensation unit 110.

A detailed description will be made of the above-described distortion compensation unit 110. As for each of the units included in the distortion compensation unit 110, description will be made of a case where the distortion compensation coefficient updating processing is performed and a case where the fault position specifying processing is performed, respectively. First, the description is made of the case where the distortion compensation coefficient updating processing is performed by the distortion compensation unit 110.

As illustrated in FIG.2, the distortion compensation unit 110 includes a distortion compensation coefficient table 111, a power calculation unit 112, a predistortion unit 113, a delay circuit 114, a distortion compensation coefficient updating unit 115, a Fast Fourier Transform (FFT) 116, a monitor control unit 117, a threshold value storage unit 118, and a fault determination unit 119.

As for each power of the transmission signals, the distortion compensation coefficient table 111 stores the distortion compensation coefficient that is used when the distorting compensation processing is performed. The distortion compensation coefficient table 111 is, for example, a Random Access Memory (RAM), a Read Only Memory (ROM), or a semiconductor memory element such as a Flash Memory, or a storage apparatus such as a hard disk or an optical disk.

The power calculation unit 112 measures the power value of the transmission signal input from the I/F 101, reads out the distortion compensation coefficient corresponding to the measured electric value from the distortion compensation coefficient table 111, and outputs the read distortion compensation coefficient to the predistortion unit 113. The predistortion unit 113 uses the distortion compensation coefficient read out by the power calculation unit 112 to compensate for the distortion occurred in the transmission signal.

The delay circuit 114 sets a time (hereinafter referred to as "delay time") taken until the feedback signal is fed back from the demodulation unit 133 to the distortion compensation unit 110 after the transmission signal is input from the I/F 101 to the distortion compensation unit 110. The delay circuit 114 delays the transmission signal by the delay time and inputs the transmission signal to the distortion compensation coefficient updating unit 115. That is, the delay circuit 114 inputs the transmission signal and the feedback signal whose timings are deviated to the distortion compensation coefficient updating unit 115 at substantially the same timing.

The distortion compensation coefficient updating unit 115 compares the transmission signal input from the delay circuit 114 with the feedback signal fed back from the demodulation unit 133 and calculates a distortion compensation coefficient based on a comparison result. For example, the distortion compensation coefficient updating unit 115 obtains a difference between the power value of the transmission signal and the power value of the feedback signal calculated by the monitor control unit 117 described below, and calculates the distortion compensation coefficient so that the obtained difference is reduced. The distortion compensation coefficient updating unit 115 updates the distortion compensation coefficient stored in the distortion compensation coefficient table 111 to the calculated distortion compensation coefficient.

The FFT 116 detects each frequency signal component of the feedback signal fed back from the demodulation unit 133 and outputs the detection result to the monitor control unit 117. Based on each of the frequency signal components of the feedback signal input from the FFT 116, the monitor control unit 117 calculates the power value of the feedback signal and inputs the calculated power value to the distortion compensation coefficient updating unit 115. As illustrated in FIG.2, the monitor control unit 117 includes a delay time control unit 117a and a coefficient update stopping unit 117b.

Based on each of the frequency signal components input from the FFT 116, the delay time control unit 117a calculates the delay time taken until the feedback signal is fed back from the demodulation unit 133 to the distortion compensation unit 110 after the transmission signal is input from the I/F 101 to the distortion compensation unit 110. The delay time control unit 117a controls the delay circuit 114 by using the calculated delay time.

The coefficient update stopping unit 117b stops or restarts the distortion compensation coefficient updating processing performed by the distortion compensation coefficient updating unit 115. For example, if the power value calculated by the wave detector 134 is or larger than the prescribed threshold value, the coefficient update stopping unit 117b determines that the feedback signal includes the unwanted wave and makes the distortion compensation coefficient updating unit 115 stop the distortion compensation coefficient updating processing. This prevents the coefficient update stopping unit 117b from updating the distortion compensation coefficient to a wrong value.

After making the distortion compensation coefficient updating unit 115 stop the distortion compensation coefficient updating processing, the coefficient update stopping unit 117b makes the distortion compensation coefficient updating unit 115 restart the distortion compensation coefficient updating processing if the power value calculated by the wave detector 134 is smaller than the prescribed threshold value. This enables the coefficient update stopping unit 117b to make the distortion compensation coefficient updating unit 115 perform the distortion compensation coefficient updating processing when there is a low possibility that the feedback signal includes the unwanted wave.

The threshold value storage unit 118 and the fault determination unit 119 are parts that are related to the fault position specifying processing. Description will be made below of the threshold value storage unit 118 and the fault determination unit 119.

Description will be made of a case where the distortion compensation unit 110 performs the fault position specifying processing. In this case, the connection of the RF switch 130 is in a state where the distributor 129 is connected to the frequency conversion down-convertor 131. That is, the demodulation unit 133 feeds back the reflected wave to the distortion compensation coefficient updating unit 115 and the FFT 116.

The FFT 116 to which the reflected wave is input detects each of the frequency signal components of the reflected wave and outputs the detection result to the monitor control unit 117. Based on each of the frequency signal components of the reflected wave, the monitor control unit 117 calculates the power value of the reflected wave and outputs the calculated power value to the fault determination unit 119. Hereinafter, the power value of the reflected wave, which is input from the monitor control unit 117 to the fault determination unit 119, is referred to as "reflection power."

Based on each of the frequency signal components input from the FFT 116, the delay time control unit 117a calculates the reflection time taken until the reflected wave is fed back from the demodulation unit 133 to the distortion compensation unit 110 after the transmission signal is input from the I/F 101 to the distortion compensation unit 110. The delay time control unit 117a outputs the calculated reflection time to the fault determination unit 119.

In this manner, the monitor control unit 117 calculates the reflection power when the distortion compensation unit 110 performs the fault position specifying processing. Furthermore, the delay time control unit 117a calculates the reflection time taken until the reflected wave is input to the distortion compensation unit 110 after the transmission signal is input to the distortion compensation unit 110. That is, the monitor control unit 117 calculates the power value of the feedback signal and the delay time when the distortion compensation coefficient updating processing is performed, and calculates the reflection power and the reflection time when the fault position specifying processing is performed. Accordingly, the radio device 100 performs the fault position specifying processing by diverting the monitor control unit 117 that is used when the distortion compensation coefficient updating processing is performed. Therefore, the radio device 100 may perform the distortion compensation coefficient updating processing without increasing the circuit scale.

The threshold value storage unit 118 is, for example, a semiconductor memory element such as a RAM, a ROM, or a storage device such as a hard disk or an optical disk, and stores a reflection time threshold value and a reflection power threshold value as a threshold value of the reflection power. For example, the threshold value storage unit 118 stores the reflection time and the reflection power, which are measured in a state where the coaxial cable 127 and the antenna 128 have no fault, as the reflection time threshold value and the reflection power threshold value, respectively. The threshold value storage unit 118 stores the time taken until the reflected wave of the transmission signal reflected in the antenna 128 is input to the distortion compensation unit 110 after the transmission signal as the reflection time threshold value is input from the I/F 101 to the distortion compensation unit 110.

The fault determination unit 119 specifies a fault position candidate based on the reflection power that is input from the monitor control unit 117, the reflection time that is input from the delay time control unit 117a, and the reflection power threshold value and the reflection time threshold value that are stored in the threshold value storage unit 118. The fault determination unit 119 stores a combination of the reflection power and the reflection time as a log in a prescribed storage unit.

For example, the fault determination unit 119 specifies the coaxial cable 127 as a fault position candidate if the reflection time is less than the reflection time threshold value stored in the threshold value storage unit 118. This is because the transmission signal is reflected on the coaxial cable 127 without reaching the antenna 128 if the reflection time is less than the reflection time threshold value. In the above-described state, there is a possibility that the coaxial cable 127 has a fault. Thus, the fault determination unit 119 specifies the coaxial cable 127 as a fault position candidate.

If the coaxial cable 127 is specified as the fault position candidate, the fault determination unit 119 specifies the fault position of the coaxial cable 127 based on the reflection time. For example, the fault determination unit 119 determines a possibility that there is a fault in a position near a radio unit 140 on the coaxial cable 127 as the difference between the reflection time threshold value and the reflection time is larger. The fault determination unit 119 determines the possibility that there is a fault in the position near the antenna 128 on the coaxial cable 127 as the difference between the reflection time threshold value and the reflection time is smaller.

The fault determination unit 119 specifies the antenna 128 as a fault position candidate if the reflection time is greater than or equal to the reflection time threshold value stored in the threshold value storage unit 118 and if the reflection power is greater than the reflection power threshold value stored in the threshold value storage unit 118. When the reflection time is greater than or equal to the reflection time threshold value, the transmission signal is reflected in the antenna 128. If the reflection power is greater than the reflection power threshold value, a large of numbers of the transmission signals are reflected in the antenna 128. In the above-described state, the antenna 128 may have a fault. Thus, the fault determination unit 119 specifies the antenna 128 as a fault position candidate.

The fault determination unit 119 determines that no fault position candidate exists if the reflection time is greater than or equal to the reflection time threshold value stored in the threshold value storage unit 118 and if the reflection power is less than or equal to the reflection power threshold value stored in the threshold value storage unit 118. In this case, the switch control unit 135 switches the connection of the RF switch 130 so that the distributor 129 is connected to the frequency conversion down-converter 131. Accordingly, the radio device 100 goes back to the state in which the distortion compensation coefficient updating processing is performed.

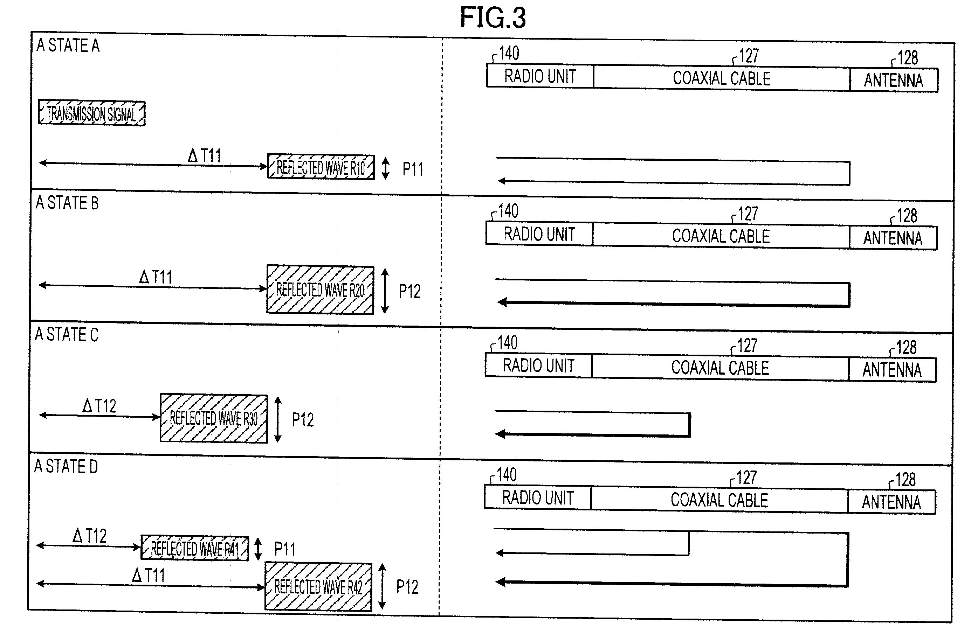

FIG.3 is a diagram illustrating an example of the fault position specifying processing performed by the fault determination unit 119. The I/F 101, the distortion compensation unit 110, and the units 121 to 126 and 129 to 133 are given as an example of the radio unit 140 illustrated in FIG.3.

State A illustrated in FIG.3 indicates an example of a case where the coaxial cable 127 and the antenna 128 have no fault. In State A illustrated in FIG.3, the transmission signal is reflected in the antenna 128. The reflection power of a reflected wave R10 of the transmission signal is "P11," and the reflection time is "ΔT11." In the example illustrated in FIG.3, the threshold value storage unit 118 stores "P11" as the reflection power threshold value and stores "ΔT11" as the reflection time threshold value.

State B illustrated in FIG.3 indicates an example of a case where the reflection power of a reflected wave R20 is "P12" and the reflection time is "ΔT11." In this case, the reflection power "P12" > the reflection power "P11" is assumed. In this case, the fault determination unit 119 specifies the antenna 128 as the fault position candidate when the reflection power "P12" is larger than the reflection power threshold value "P11," and the reflection time "ΔT11" is equal to the reflection time threshold value "ΔT11."

State C illustrated in FIG.3 indicates an example of a case where the reflection power of a reflected wave R30 is "P12," and the reflection time is "ΔT12." In this case, the reflection time "ΔT11" > the reflection time "ΔT12" is assumed. In this case, the fault determination unit 119 determines that the coaxial cable 127 is the fault position candidate because the reflection time is "ΔT12" is smaller than the reflection time "ΔT11."

The fault determination unit 119 determines the fault position on the coaxial cable 127 based on the reflection time "ΔT12." For example, the coaxial cable 127 is long enough compared to the length of the path from the I/F 101 to the coaxial cable 127, so that the time taken until the transmission signal is input to the coaxial cable 127 after the transmission signal is output from the I/F 101 may be ignored. Due to the substantially same reason, the time taken until the reflected wave is input to the distortion compensation unit 110 after the reflected wave is output from the coaxial cable 127 may be ignored. In this case, the fault determination unit 119 specified the position near the middle of the coaxial cable 127 as the fault position if, for example, the reflection time "ΔT12" is half as large as the reflection time threshold value "ΔT11."

State D illustrated in FIG.3 is an example of existence of two reflected waves: a reflected wave R41 and a reflected wave R42. In this case, the reflection power of the reflected wave R41 is "P11," and the reflection time is "ΔT12." The reflection power of the reflected wave R42 is "P12," and the reflection time is "ΔT11." In this case, the fault determination unit 119 specifies both the coaxial cable 127 and the antenna 128 as a fault position candidate.

For example, the example illustrated in State D illustrates that some of the transmission signals are reflected on the coaxial cable 127 and a large number of the transmission signals that reach the antenna 128 are reflected in the antenna 128. Accordingly, the fault determination unit 119 determines that both the coaxial cable 127 and the antenna 128 may have a fault.

The above-described State C illustrates the example of processing for specifying the fault position of the coaxial cable 127 on the assumption that the coaxial cable 127 is long enough compared to the length of the path from the I/F 101 to the coaxial cable 127. The above-described example illustrates that the time taken until the transmission signal is input to the coaxial cable 127 after the transmission signal is output from the I/F 101 and the time taken until the reflected wave is input to the distortion compensation unit 110 after the reflected wave is output from the coaxial cable 127 may be ignored. However, even if the above-described assumption is not made, the fault determination unit 119 is able to specify the fault position of the coaxial cable 127.

For example, the fault determination unit 119 may specify the fault position of the coaxial cable 127 based on a rate of the reflection time and the reflection time threshold value. In this case, the radio device 100 holds information indicating the fault position of the coaxial cable 127 in association with the rate of the reflection time and the reflection time threshold value. If the rate of the reflection time and the reflection time threshold value is "6:10," the fault determination unit 119 determines, for example, that the position near the middle of the coaxial cable 127 as the fault position.

For example, the distortion compensation unit 110 may hold a time T1 taken until the transmission signal is input to the coaxial cable 127 after the transmission signal is output from the I/F 101 and a time T2 taken until the reflected wave is input to the distortion compensation unit 110 after the reflected wave is output from the coaxial cable 127. In this case, by subtracting the time T1 and the time T2 from the reflection time, the fault determination unit 119 calculates a time T3 during which the signal travels and returns on the path from the coaxial cable 127 to the antenna 128. The fault determination unit 119 calculates a time T4 by subtracting the time T1 and the time T2 from the reflection time threshold value. The fault determination unit 119 specifies the fault position on the coaxial cable 127 by comparing the calculated time T3 to the calculated time T4. For example, if the value of the time T3 is half as large as the time T4, the fault determination unit 119 determines that there is a fault near the middle of the coaxial cable 127.

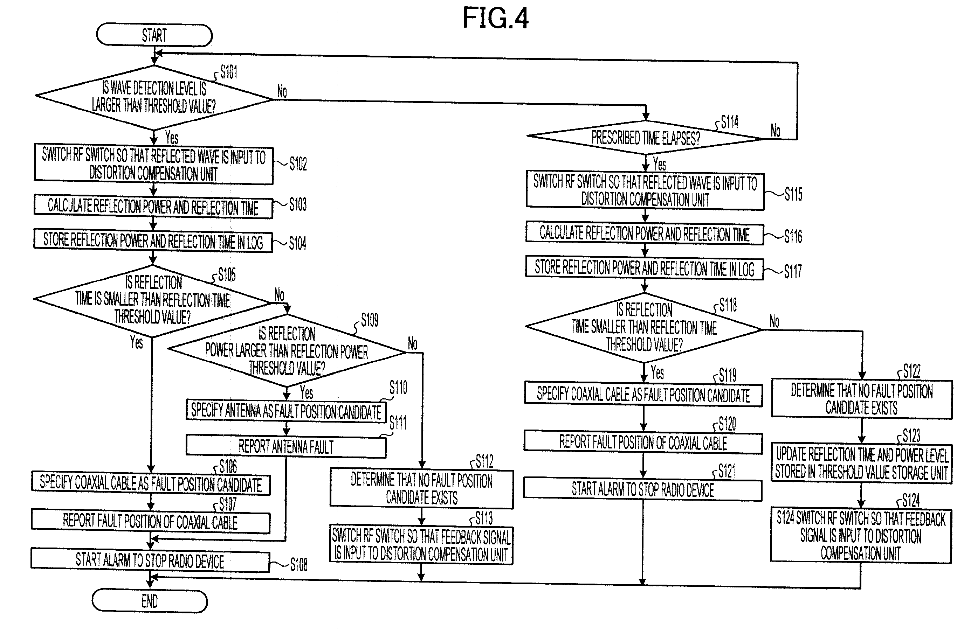

FIG.4 is a flowchart illustrating the fault position specifying processing procedure by the radio device 100 according to the second embodiment.

As illustrated in FIG.4, the switch control unit 135 of the radio device 100 determines whether the power value of the signal, which includes the reflected wave and the unwanted wave calculated by the wave detector 134, is greater than the detection wave threshold value (Operation S101). If the power value calculated by the wave detector 134 is greater than the detection wave level threshold value (YES in Operation S101), the switch control unit 135 switches the connection of the RF switch 130 so that the reflected wave is input to the distortion compensation unit 110 (Operation S102).

The reflected wave that is output from the coaxial cable 127 is input to the demodulation unit 133 through the circulator 126, the distributer 129, the RF switch 130, the frequency conversion down-convertor 131, and the ADC 132. The demodulation unit 133 to which the reflected wave is input outputs the demodulated reflected wave to the FFT 116. The FFT 116 to which the reflected wave is input detects each of the frequency signal components of the reflected wave and outputs the detection result to the monitor control unit 117.

The monitor control unit 117 calculates the reflection power based on each of the frequency signal components of the reflected wave that is input from the FFT 116 (Operation S103). The delay time control unit 117a calculates a reflection time based on each of the frequency signal components of the reflected wave that is input from the FFT 116 (Operation S103).

The fault determination unit 119 stores, in a log, the reflection power that is calculated by the monitor control unit 117 and the reflection time that is calculated by the delay time control unit 117a (Operation S104). The fault determination unit 119 compares the reflection power threshold value to the reflection power stored in the threshold value storage unit 118 and compares the reflection time threshold value to the reflection time stored in the threshold value storage unit 118 (Operation S105).

If the reflection time is less than the reflection time threshold value (YES in Operation 105), the fault determination unit 119 specifies the coaxial cable 127 as a fault position candidate (Operation S106). Based on the reflection time, the fault determination unit 119 specifies the fault position of the coaxial cable 127, stores the specified fault position in the log, and reports the specified fault position to the administrator (Operation S107). The fault determination unit 119 starts an alarm to stop the radio device 100 (Operation S108).

If the reflection time greater than or equal to the reflection time threshold value (NO in Operation S105) and if the reflection power is greater than the reflection power threshold value (YES in Operation S109), the fault determination unit 119 specifies the antenna 128 as the fault position candidate (Operation S110). The fault determination unit 119 stores the fact that the antenna has a fault and reports the fact to the administrator (Operation S111). The fault determination unit 119 starts the alarm to stop the radio device 100 (Operation S108).

If the reflection time is greater than or equal to the reflection time threshold value (NO in Operation S105) and if the reflection power is or smaller than the reflection power threshold value (NO in Operation S109), the fault determination unit 119 determines that no fault position candidate exists (Operation S112). In this case, the switch control unit 135 switches the connection of the RF switch 130 so that the feedback signal is input to the distortion compensation unit 110 (Operation S113).

On the other hand, if the power value calculated by the wave detector 134 is less than or equal to the detection wave level threshold (NO in Operation S101), the switch control unit 135 determines whether the prescribed time elapses (Operation S114). When the prescribed time elapses (YES in Operation S114), the switch control unit 135 switches the connection of the RF switch 130 so that the reflected wave is input to the distortion compensation unit 110 (Operation S115).

The monitor control unit 117 calculates the reflection power, and the delay time control unit 117a calculates the reflection time (Operation S116). The fault determination unit 119 stores, in the log, the reflection power calculated by the monitor control unit 117 and the reflection time calculated by the delay time control unit 117a (Operation S117).

If the reflection time is less than the reflection time threshold value (YES in Operation S118), the fault determination unit 119 specifies the coaxial cable 127 as the fault position candidate (Operation S119). Based on the reflection time, the fault determination unit 119 specifies the fault position of the coaxial cable 127, stores the specified fault position in the log, and reports the specified fault position to the administrator (Operation S120). The fault determination unit 119 starts the alarm to stop the radio device 100 (Operation S121).

If the reflection time greater than or equal to the reflection time threshold value (NO in Operation S118), the fault determination unit 119 determines that no fault position candidate exists (Operation S122). In this case, the fault determination unit 119 updates the reflection power threshold value stored in the threshold value storage unit 118 to the reflection power calculated by the monitor control unit 117 (Operation S123). The fault determination unit 119 updates the reflection time threshold value stored in the threshold value storage unit 118 to the reflection time calculated by the delay time control unit 117a (Operation S123). In this manner, if no fault position candidate exists, the fault determination unit 119 updates the reflection power threshold value and the reflection time threshold value that may be changed according to an operating environment or the like. Accordingly, even when the reflection power or the reflection time is changed according to a change of the operating environment, the radio device 100 may properly perform the fault position specifying processing.

The switch control unit 135 switches the connection of the RF switch 130 so that the feedback signal is input to the distortion compensation unit 110 (Operation S124).

In the example illustrated in FIG.4, if the power value calculated by the wave detector 134 less than or equal to the detection wave level threshold value (NO in Operation S101) and if the prescribed time elapses (YES in Operation S114), the fault determination unit 119 does not compare the reflection power to the reflection power threshold value. This is because, as for the radio device 100 according to the second embodiment, it is assumed that the reflection power is not greater than the reflection power threshold value if the power value calculated by the wave detector 134 less than or equal to the detection wave level threshold value. Even if the power value calculated by the wave detector 134 is less than or equal to the detection wave level threshold value, the fault determination unit 119 may determine whether the antenna 128 has a fault by performing processing for comparing the reflection power to the reflection power threshold value.

As described above, if the reflection time is less than the radio device 100 according to the second embodiment specifies the fault position candidate on the coaxial cable 127 based on the reflection time. This enables the administrator or the like who manages the radio device 100 may easily determine whether the coaxial cable 127 has a fault based on the fault position candidate specified by the radio device 100.

The radio device 100 according to the second embodiment calculates the reflection power by using the delay time control unit 117a that calculates the delay time when the distortion compensation coefficient updating processing is performed. This enables the radio device 100 to perform the fault position specifying processing without increasing the circuit scale.

If the reflection power is greater than the reflection power threshold value, the radio device 100 according to the second embodiment specifies the antenna 128 as the fault position candidate. This enables the administrator or the like to check if the antenna 128 has a fault.

The radio device 100 according to the second embodiment performs the fault position specifying processing by using the reflected wave of the transmission signal that includes the user data or the control data. Accordingly, the radio device 100 may specify the fault position candidate without using a test signal such as a pilot signal. That is, the radio device 100 may specify the fault position candidate during operation.

The radio device 100 according to the second embodiment stores the reflection power and the reflection time in the log every time the reflection power and the reflection time are calculated. Consequently, when a fault occurs, the administrator or the like may determine whether the fault occurs gradually or the fault occurs suddenly by checking the log. For example, the radio device 100 specifies the antenna 128 as the fault position candidate. In this case, the administrator or the like checks the above-described log to determine the fault of the antenna 128 occurs gradually if the reflection power is increasing gradually. On the other hand, if the reflection power increases suddenly, the administrator or the like may determine that the fault of the antenna 128 occurs suddenly.

The radio device 100 according to the second embodiment calculates the power value of the signal, which includes the reflected wave and the unwanted wave, by using the wave detector 134 and switches the RF switch 130 so that the signal to be fed back to the distortion compensation unit 110 becomes the reflected wave. This enables the radio device 100 to perform the fault position specifying processing if the reflection power is greater than the reflection power threshold value.

The radio device 100 according to the second embodiment determines that no fault position exists if the reflection power less than or equal to the reflection power threshold value and if the reflection time is greater than or equal to the reflection time threshold value. This enables the radio device 100 to accurately determine whether a fault position exists even when receiving the unwanted wave.

Every time the prescribed time elapses, the radio device 100 switches the RF switch 130 so that the signal to be input to the distortion compensation unit 110 becomes the reflected wave. This enables the radio device 100 to determine whether the coaxial cable 127 has a fault by regularly performing the fault position specifying processing even if the power value calculated by the wave detector 134 is less than the detection wave level threshold value.

The above-described radio device or the like may be used in various configurations other than the above-described embodiments. In a third embodiment, description is made of other embodiments.

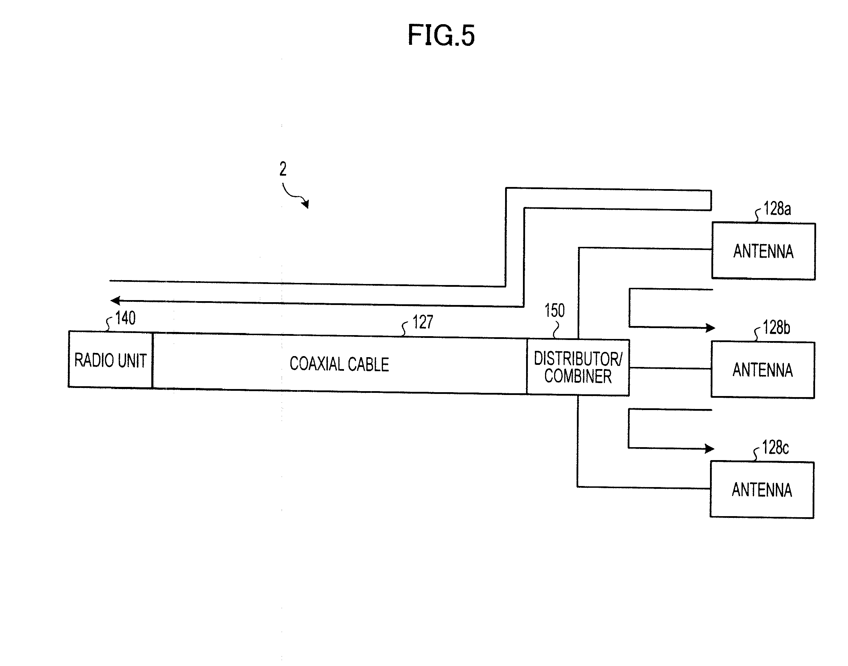

In the above-described first and second embodiments, description was made of a case where, for example, the radio device includes a single antenna. However, a radio device that includes a plurality of antennas may be used. FIG.5 is a diagram illustrating a configuration example of a radio device that includes a plurality of antennas. A radio device 2 illustrated in FIG.5 includes a distributor/combiner 150. The distributor/combiner 150 is connected to antennas 128a to 128c.

In the radio device 2 illustrated in FIG.5, there are various patterns in which the transmission signal, which is input from the radio unit 140 to the coaxial cable 127, is reflected on the path from the coaxial cable 127 to antennas 128a to 128c. For example, the transmission signal may be input to the radio unit 140 after being reflected in the antenna 128a, may be input to the radio unit 140 after being reflected in the antenna 128b, or may be input to the radio unit 140 after being reflected in the antenna 128c. The transmission signal may be reflected in the antenna 128b after being reflected in the antenna 128a and then input to the radio unit 140.

The radio device 2 holds the reflection time threshold value for each pattern in which the transmission signal is reflected. For example, the radio device 2 holds the reflection time threshold value in the case where the transmission signal is reflected in the antenna 128a, the reflection time threshold value in the case where the transmission signal is reflected in the antenna 128b, or the reflection time threshold value in the case where the transmission signal is reflected in the antenna 128c. The radio device 2 holds the reflection time threshold value in the case where the transmission signal is reflected in the antenna 128b or the antenna 128c after the transmission signal is reflected in the antenna 128a.

If the reflection time calculated by the delay time control unit 117a is less than any of the reflection time threshold values, the fault determination unit 119 of the radio device 2 specifies the coaxial cable 127 as the fault position candidate. In this manner, the radio device 2 may specify the fault position by holding the reflection time threshold value for each pattern even if the radio device 2 includes the plurality of antennas.

The configuration elements of each device illustrated in the figures are functionally conceptual and may be physically configured differently than shown in the figures. That is, specific configurations of distribution and integration of the devices are not limited to the figures. All or some of the devices may be configured to be distributed or integrated by an arbitrary unit functionally or physically according to each load or use condition. FIG.2 illustrates the example of a case where the reflection power and the reflection time used for the fault position specifying processing by diverting the monitor control unit 117 that is used when the distortion compensation coefficient updating processing is performed. The radio device 100 may be provided with a circuit, which calculates the reflection power and the reflection time, separately from the monitor control unit 117 that is used to when the distortion compensation coefficient updating processing is performed.

From among the processing described in the above-described embodiments, all or some of the processing that were described to be automatically performed may be performed manually. Alternatively, all or some of the processing that are to be manually performed may be performed automatically by a known method. For example, in the example illustrated in FIG.1, reflection time calculating processing by the reflection time calculation unit 14 may be performed manually. In the example illustrated in FIG.1, the fault position specifying processing by the fault position specifying unit 15 may be performed manually. For example, the reflection time is checked manually by the reflection time calculation unit 14 to specify the fault position candidate.

All examples and conditional language recited herein are intended for pedagogical purposes to aid the reader in understanding the principles of the invention and the concepts contributed by the inventor to furthering the art, and are to be construed as being without limitation to such specifically recited examples and conditions. Although the embodiment(s) of the present invention(s) have been described in detail, it should be understood that the various changes, substitutions, and alterations could be made hereto without departing from the spirit and scope of the invention.

## Claims

1. A radio device comprising:
a radio unit to perform modulation processing on a signal;
an antenna to transmit and receive signals to and from an external unit;
a cable to connect the radio unit to the antenna;
a reflection time calculation unit to calculate a reflection time taken from after the transmission signal is input into a prescribed part of the radio unit until a transmission signal which is output from the radio unit is reflected on a path from the cable to the antenna is fed back to the prescribed part of the radio device; and
a fault position specifying unit to specify a position candidate at which a fault occurs on the cable based on the calculated reflection time when the calculated reflection time is less than a reflection time threshold value.

2. The radio device according to claim 1, wherein the radio unit comprises:
a distortion compensation unit to compensate for a distortion which occurs in the transmission signal, based on a feedback signal obtained by feeding back the transmission signal which is output to the cable;
the distortion compensation unit including,
a delay time control unit to calculate a delay time taken from after the transmission signal is input to the distortion compensation unit until the feedback signal is fed back to the distortion compensation unit;
a distortion compensation coefficient calculation unit to calculate a distortion compensation coefficient, which is used when the distortion compensation unit performs distortion compensation processing, based on the transmission signal delayed by the calculated delay time and on the feedback signal; and
a selection unit to perform a selection of a signal to be input to the distortion compensation unit, the signal being the feedback signal or a reflected wave as the signal reflected on a path from the cable to the antenna;
wherein when the selection unit selects the reflected wave, the reflection time calculation unit uses the delay time, based on the transmission signal and the reflected wave, as a calculated reflection time.

3. The radio device according to claims 1 or 2, wherein the radio unit further comprises a power calculation unit to calculate a power of a feedback signal,
wherein the power calculation unit calculates a power value of a reflected wave when the selection unit selects the reflected wave, and
wherein the fault position specifying unit specifies the antenna as a fault position candidate when the power value is greater than a reflection power threshold value and when the reflection time calculated is greater than or equal to the reflection time threshold value.

4. The radio device according to claim 3, wherein the fault position specifying unit stores, in a log, the reflection time and the power value.

5. The radio device according to claim 2, further comprising a wave detector to calculate a power value of the signal which is output from the antenna through the cable,
wherein the selection unit selects the reflected wave when the calculated power value is greater than the detection wave level threshold value.

6. The radio device according to claim 5, wherein the fault position specifying unit determines that there is no fault position candidate when the calculated power value is less than or equal to a reflection power threshold value and when the calculated reflection time is greater than or equal to the reflection time threshold value.

7. The radio device according to claim 2, wherein, each time a specified time elapses, the selection unit alternately selects the feedback signal or the reflected wave.

8. A fault position specifying method which is used to specify a fault position of a radio device which includes a radio unit performing modulation processing on a signal, an antenna transmitting and receiving the signal, and a cable connecting the radio unit to the antenna, the fault position specifying method comprising:
calculating, by a reflection time calculation unit, a reflection time as a time taken from after a transmission signal is input to a prescribed part of the radio unit until a reflected wave as a signal reflected on a path from the cable to the antenna is fed back to the prescribed part of the radio unit ; and
specifying, by a fault position specifying unit, a fault position candidate on the cable based on the reflection time when the calculated reflection time is less than a reflection time threshold value.

9. The fault position specifying method according to claim 8, wherein the method further comprises:
compensating, by a distortion compensation unit, for a distortion which occurs in the transmission signal, based on a feedback signal obtained by feeding back the transmission signal which is output to the cable;
the compensating further including,
calculating, by a delay time control unit, a delay time taken from after the transmission signal is input to the distortion compensation unit until the feedback signal is fed back to the distortion compensation unit;
calculating, by a distortion compensation coefficient calculation unit, a distortion compensation coefficient, which is used when the distortion compensation unit performs distortion compensation processing, based on the transmission signal delayed by the calculated delay time and on the feedback signal; and
selecting, by a selection unit, a signal to be input to the distortion compensation unit, the signal being the feedback signal or a reflected wave as the signal reflected on a path from the cable to the antenna;
wherein when the selection unit selects the reflected wave, the reflection time calculation unit uses the delay time, based on the transmission signal and the reflected wave, as a calculated reflection time.

10. The fault position specifying method according to claim 8, wherein the method further comprises calculating, by a power calculating unit, a power of a feedback signal,
wherein the power calculation unit calculates a power value of a reflected wave when the selection unit selects the reflected wave, and
wherein the fault position specifying unit specifies the antenna as a fault position candidate when the power value is greater than a reflection power threshold value and when the reflection time calculated is greater than or equal to the reflection time threshold value.

11. The fault position specifying method according to claim 9, wherein the method further comprises calculating, by a power calculating unit, a power of a feedback signal,
wherein the power calculation unit calculates a power value of a reflected wave when the selection unit selects the reflected wave, and
wherein the fault position specifying unit specifies the antenna as a fault position candidate when the power value is greater than a reflection power threshold value and when the reflection time calculated is greater than or equal to the reflection time threshold value.

12. The fault position specifying method according to claim 10, wherein the fault position specifying unit stores, in a log, the reflection time and the power value.

13. The fault position specifying method according to claim 9, further comprising calculating, by a wave detector, a power value of the signal which is output from the antenna through the cable,
wherein the selection unit selects the reflected wave when the calculated power value is greater than the detection wave level threshold value.

14. The fault position specifying method according to claim 12, wherein the fault position specifying unit determines that there is no fault position candidate when the calculated power value is less than or equal to a reflection power threshold value and when the calculated reflection time is greater than or equal to the reflection time threshold value.

15. The fault position specifying method according to claim 9, wherein, each time a specified time elapses, the selection unit alternately selects the feedback signal or the reflected wave.
